# EUROPEAN PATENT APPLICATION

(11) **EP 2 088 594 A1**
(43) Date of publication of application: **12.08.2009**
(21) Application number: 08740191.5
(22) Date of filing: 10.04.2008
(51) Int. Cl.: G11B 7/258, C23C 14/06, C23C 14/14, C23C 14/34

(54) **OPTICAL INFORMATION RECORDING MEDIUM**

(30) Priority: 13.04.2007 JP 2007106344
(71) Applicant: Sony Disc & Digital Solutions Inc., Shinagawa-ku Tokyo 141-0001 (JP); Kabushiki Kaisha Kobe Seiko Sho, Chuo-ku Kobe-shi Hyogo 651-8585 (JP); Kobelco Research Institute , Inc., Kobe-shi Hyogo 651-0073 (JP)
(72) Inventor: OKAWA, Naoki, Tokyo 141-0001 (JP); TAUCHI, Yuki, HYOGO 676-8670 (JP); NAKAI, Junichi, HYOGO 651-2271 (JP)
(74) Representative: Müller - Hoffmann & Partner
(86) International application number: PCT/JP2008/057090
(87) International publication number: WO 2008/133020

(57) **Abstract**

There is provided a read-only optical information recording medium including a reflective film which has high reflectivity, and is superior in environment resistance at the time of being kept in a high-temperature, high humidity environment as well as light resistance at the time of being kept in a high-intensity light irradiation environment and repeating reproduction durability against a repeating reproduction test. In a read-only optical information recording medium in which at least one reflective film and at least one light transmissive layer are laminated in order on a substrate, the reflective film is made of a Ag-base alloy including 0.01 to 1.0 at% of Bi and 0.1 to 13.0 at% of Cu.

## Description

### TECHNICAL FIELD

The present invention relates to a read-only optical information recording medium such as, for example, a CD-ROM (Read Only Memory), a DVD-ROM, a BD (blu-ray disc)-ROM or an HD DVD-ROM, and specifically to a read-only optical information recording medium using blue laser light to perform reproduction such as a BD or an HD DVD.

### BACKGROUND ART

Optical information recording media (optical disks) are broadly divided into three types, that is, a read-only type, a write-once type and a rewritable type on the basis of the principle of recording and reproduction.

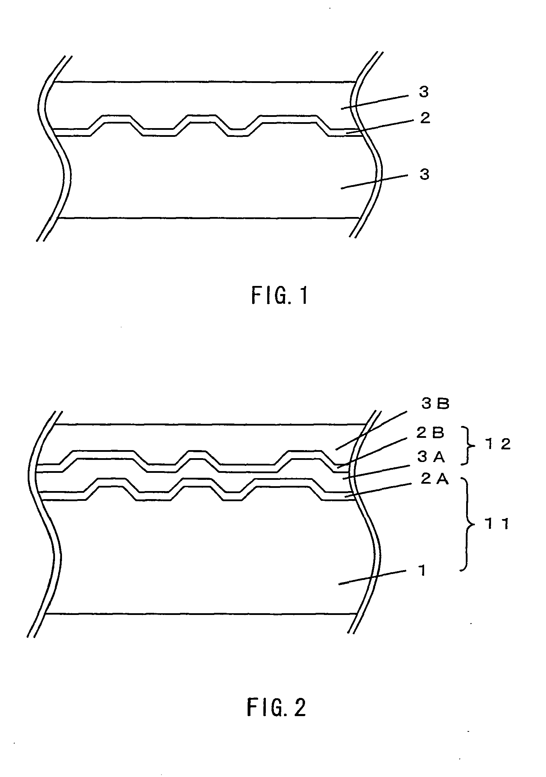

FIG. 1 schematically shows a typical configuration of a read-only optical disk. The read-only optical disk has a configuration in which a reflective film 2 including Ag (silver), Al (aluminum), Au (gold) or the like as a main component, and a light transmissive layer 3 are laminated in order on a substrate 1 made of transparent plastic or the like. Information by combinations of projections and depressions, that is, lands and pits (recorded data) is stored on the substrate 1, and, for example, a substrate made of polycarbonate with a thickness of 1.1 mm and a diameter of 12 cm is used as the substrate 1. The light transmissive layer 3 is formed by bonding a light transmissive sheet, or coating with a light transmissive resin and curing the light transmissive resin. The reproduction of recorded data is performed by detecting a phase difference or a reflection difference of laser light applied to the optical disk.

An example of FIG. 1 shows a single-layer optical disk including one reflective film 2 and one light transmissive layer 3 on the substrate 1; however, for example, as shown in FIG. 2, a dual-layer optical disk including a first information recording surface 11 and a second information recording surface 12 is also used. In other words, the dual-layer optical disk has a configuration in which a first reflective film 2A, a first light transmissive layer 3A, a second reflective film 2B and a second light transmissive layer 3B are laminated in order on the substrate 1 on which information by combinations of projections and depressions, that is, lands and pits (recorded data) is stored. On the first light transmissive layer 3A, different information from the information stored on the substrate 1 is stored by combinations of pits and lands.

As the reflective film used in the optical disk, Au, Cu (copper), Ag, Al and alloys including them as main components have been heretofore used.

Among them, a reflective film including Au as a main component has advantages that chemical stability is superior, and a change in recording characteristics with time is small. Such a reflective film is extremely expensive, and has an issue that sufficiently high reflectivity with respect to blue laser light (with a wavelength of 405 nm) used for recording/reproduction on a BD or an HD DVD is not obtained. Moreover, a reflective film including Cu as a main component is inexpensive; however, the reflective film has the lowest chemical stability among conventional reflective film materials. Further, as in the case of Au, the reflective film has a disadvantage that reflectivity with respect to blue laser light is low, so the application of the reflective film is limited. A reflective film including Al as a main component has a disadvantage that its chemical stability is lower than that of a Ag-based or Au-based reflective film.

On the other hand, a reflective film including Ag as a main component exhibits sufficiently high reflectivity in a range from 400 nm to 800 nm as a practical wavelength region, and at present, in an optical disk using a blue laser, a metal for the reflective film which can be used in the light of optical characteristics such as reflectivity and transmittance is Ag only. However, pure Ag is inferior to a Au-based reflective film in terms of a change in chemical stability or recording characteristics with time (thermal stability of a crystalline texture). Therefore, various Ag-base alloys have been proposed for the purpose of improving durability (for example, refer to Patent Documents 1 to 4).

In Patent Document 1, a Ag-base alloy including an element of Au, Cu, Pd (palladium), Rh (rhodium) or the like is disclosed, and in Patent Document 2, a Ag-base alloy including an element of Zn (zinc) or the like is disclosed. In Patent Documents 3 and 4, reflective films for optical disks by the same applicant as that of the present invention are disclosed. Among them, in Patent Document 3, a reflective film which reduces a change in crystalline texture with time by adding a rare earth element such as Nd (neodymium) to Ag is disclosed, and in Patent Document 4, a reflective film of which the durability at the time of being kept in a high-temperature, high humidity environment is improved by adding Bi (bismuth) to Ag is disclosed.

However, demands for durability of a reflective film for an optical disk have been increasing, and in particular, in an optical disk using a blue laser such as a BD-ROM or an HD DVD-ROM, higher durability (a reduction in time degradation) is demanded. Typically, in the reflective film for an optical disk, in addition to high reflectivity, a small change in disk characteristics (environment resistance) at the time of being kept in a high-temperature, high humidity environment for assessing time degradation is demanded. Moreover, in an optical disk using a blue laser, in addition to the above-described characteristics, for example, a small change in characteristics (light resistance) in a test (an accelerated light irradiation test) which is performed by keeping the optical disk in a high-intensity light irradiation environment to assess degradation in disk characteristics at the time of applying sunlight or light of a fluorescent lamp, or superior durability (repeating reproduction durability) against a test for assessing a change in characteristics at the time of repeating reproduction is demanded. It is because, for example, in a BD-ROM, the thickness of a light transmissive layer formed on a reflective film on a side where laser light for reading enters is approximately 100 µm, and is thinner than that in a CD or a DVD which is a conventional optical disk, so an effect of protecting the reflective film by the light transmissive layer is small. Therefore, the reflective film used in a BD-ROM or the like needs higher durability than ever before.
Patent Document 1: Japanese Unexamined Patent Application Publication No. H6-208732
Patent Document 2: Japanese Unexamined Patent Application Publication No. 2002-117587
Patent Document 3: Japanese Unexamined Patent Application Publication No. 2002-15464
Patent Document 4: Japanese Patent No. 3655907

### DISCLOSURE OF THE INVENTION

In view of the foregoing, it is an object of the invention to provide an optical information recording medium which includes a reflective film having high reflectivity, and having a small change in disk characteristics at the time of being kept at a high-temperature, high humidity environment (being superior in environment resistance) as well as being superior in light resistance at the time of being kept in a high-intensity light irradiation environment and durability (repeating reproduction durability) against a repeating reproduction test, and in particular, being suitably used for an optical disk using a blue laser such as a DB-ROM or an HD DVD-ROM and being extremely superior in durability.

A first optical information recording medium of the invention is a read-only optical information recording medium in which at least one reflective film and at least one light transmissive layer are laminated in order on a substrate, and the reflective film is an alloy (Ag-base alloy) including Ag as a main component. The Ag-base alloy includes 0.01 to 1.0 at% of Bi and 0.1 to 13.0 at% of Cu.

A second optical information recording medium of the invention is a read-only optical information recording medium in which a first reflective film, a first light transmissive layer, a second reflective film and a second light transmissive layer are laminated in order on a substrate, and the first reflective film and the second reflective film are made of a Ag-base alloy including 0.01 to 1.0 at% of Bi and 0.1 to 3.0 at% of Cu. The compositions of the first reflective film and the second reflective film may be the same as or different from each other, as long as the above-described requirements are satisfied. Preferably, the Ag-base alloy is a Ag-base alloy including 0.05 to 1.0 at% of a rare earth element, for example, Nd. Moreover, the reproduction of information is desirably performed by a blue laser.

According to the invention, a read-only optical information recording medium including a reflective film which has high reflectivity, and is superior in environment resistance as well as light resistance and repeating reproduction durability can be provided.

### BRIEF DESCRIPTION OF THE DRAWINGS

[FIG. 1] FIG. 1 is a schematic sectional view showing a main part in a circumferential direction of a read-only optical disk (a single-layer optical disk).
[FIG. 2] FIG. 2 is a schematic view showing a main part in a circumferential direction of another read-only optical disk (a dual-layer optical disk).

### BEST MODE(S) FOR CARRYING OUT THE INVENTION

The present inventors have conducted a keen examination in order to provide a read-only optical information recording medium including a reflective film which is superior in durability (environment resistance, light resistance, repeating reproduction durability), specifically an optical information recording medium suitably used as a BDROM or an HD DVD-ROM which uses a blue laser to perform reproduction.

As a result, it turned out that in the BD-ROM, when the same data unit was repeatedly reproduced approximately a few tens of million times, read errors were increased, and it became impossible to read. On the basis of this basic experiment, the present inventors have conducted more examinations considering that "unlike in the past, it is not sufficient to assess durability by a typical durability test (an accelerated environmental test in which the BD-ROM is stored in a high-temperature, high humidity environment at a temperature of 80°C and a relative humidity of approximately 85%, or an accelerated light irradiation test in which the BD-ROM is kept under the irradiation of light with higher intensity than that in a normal environment) used for an optical information recording medium, and it is necessary to provide a reflective film which is extremely superior also in repeating reproduction durability". As a result, it was found out that (a) when a Ag-Bi-Cu alloy including predetermined amounts of Bi and Cu was used, a reflective film which had high reflectivity, and was superior in environment resistance and superior light resistance as well as extremely superior in repeating reproduction durability was obtained, and (b) when a Ag-Bi-Cu-rare earth alloy including a rare earth element in the above-described Ag-Bi-Cu alloy was used, the environment resistance was further improved, thereby the present invention was completed.

In addition, in this description, "superior in durability" means superior in all of environment resistance at the time of being kept at a high-temperature, high humidity environment, light resistance at the time of being kept in a high-intensity light irradiation environment, and repeating reproduction durability against the repeating reproduction test.

More specifically, "superior in environment resistance" means that when an accelerated environmental test in which a medium is kept in an environment at a temperature of 80°C and a relative humidity of approximately 85% for 240 hours is performed to measure a change in reflectivity before and after the accelerated environmental test, the amount of change in reflectivity is within ±3%. Thereby, durability at the time of long-term storage at high temperature and high humidity can be assessed.

Moreover, "superior in light resistance" means that when an accelerated light irradiation test in which light with intensity 20 times higher than that in a normal indoor environment is applied to a medium for 240 hours is performed to measure a change in reflectivity before and after the accelerated light irradiation test, the amount of change in reflectivity is within ±3%.

"Superior in repeating reproduction durability" means that as will be described in detail in an undermentioned example, when the reproduction of a single data unit is performed 12 million times to measure a symbol error rate (SER) as an indicator of read signal error, the SER is 10×10⁻⁴ or less.

Hereinafter, a Ag-base alloy used in the invention will be described below together with the way the above-described configuration was achieved.

To develop a novel Ag-base alloy being superior in durability, the present inventors conducted specific examinations about an influence exerted on durability (specifically repeating reproduction durability) by Bi, a rare earth element and various Z-group elements in a Ag-base alloy disclosed in the above-described Patent Document 4, more specifically a Ag-Bi-Z-group element (in this case, the Z-group element means a group of elements of "Cu, Au, Rh, Pd and Pt (platinum)" disclosed in Patent Document 4) or a Ag-Bi-Z-group element-rare earth element alloy as a base. More specifically, after various Ag alloy thin films were formed on polycarbonate substrates on which pits and lands were formed by a sputtering method using Ag-base alloy sputtering targets with various compositions, single-layer BD-ROM disks in which a light transmissive layer made of an UV curable resin was formed were formed, and various kinds of durability were examined. As a result, the following was found out.

At first, it was found that to secure superior environment resistance and superior light resistance while maintaining a conventional characteristic demanded of an optical information recording medium, that is, high reflectivity, the addition of Bi was absolutely necessary. In addition, the repeating reproduction durability is not yet considered here. As shown in an undermentioned example, compared to a group to which Bi was not added, in a group to which Bi was added, the above-described characteristics were improved. It is guessed that the environment resistance was improved because the dispersion of Ag atoms and an increase in surface roughness due to heat were prevented by the addition of Bi, so a decline in reflectivity after the accelerated environmental test could be greatly reduced. Moreover, as a result of a light resistance test, a change in a jitter value after the light resistance test was small (not shown in a table), but a decline in reflectivity was observed. The reason was not specifically clear; however, it is guessed that reaction between an unreacted component or the like in the ultraviolet curable resin directly laminated on a Ag-base alloy reflective film and a rare earth element or the like included in the Ag-base alloy causes the decline.

However, it was found out that the repeating reproduction durability was not able to be improved only by adding Bi (refer to the undermentioned example). When a reflective film made of a Ag-Bi-base alloy not including Cu was analyzed by a scanning electron microscope to probe the cause of degradation in repeating reproduction, the deposition of Ag particles was observed on the laser light incident side of the reflective film, so it is guessed that laser scattering and a change in a pit shape caused an increase in the SER.

Therefore, to improve repeating reproduction durability, experiments using various kinds of Z-group elements added to a Ag-Bi-base alloy as a base were performed. As a result, it was found out that only in the case where Cu among elements included in the Z group was used, the repeating reproduction durability was improved (refer to the undermentioned example). More specifically, in the case where Cu was added, even if the repeating reproduction test was performed while maintaining superior characteristics (high reflectivity, superior environment resistance and superior light resistance) by the Ag-Bi alloy, an increase in the SER was not observed at all. It is guessed that a Cu oxide layer or the like is formed on an interface of the ultraviolet curable resin of the reflective film by adding Cu which is susceptible to oxidation, compared to Ag, and the Cu oxide layer functions as a protective layer, and has an effect of preventing the surface diffusion of Ag atoms.

On the other hand, in the case where Z-group elements except for Cu were used, as shown in the undermentioned example, the same effect of improving the repeating reproduction durability as that in the case where Cu was added was not observed at all. The reason was not specifically clear, but it is guessed that Pd, Au, Pt and Rh are chemically stable, and have resistance to oxidation which is equivalent to or higher than the resistance of Ag, so an oxide protective layer was not formed on a surface, and the same effect of improving the repeating reproduction durability as that in the case where Cu is added was not effectively exerted. In addition, in the undermentioned example, data in the case where Rh is added is not shown, but it is guessed that Rh is the same noble metal element as Au or Pd, and does not contribute to improvement in the repeating reproduction durability.

In addition, a durability test was performed on a Ag alloy with the addition of Zn instead of the Z-group elements disclosed in Patent Document 2; however, as shown in the undermentioned example, only the same result as that in the case where Pd or the like was used was obtained, and the repeating reproduction durability declined.

Therefore, it turned out that specifically, only in the case where a Ag-Bi-Cu alloy including Cu was used, a read-only optical information recording medium satisfying all desired characteristics was obtained.

Moreover, when the present inventors examined the influence exerted on durability by a rare earth element, it turned out that when a rare earth element was further added to the Ag-Bi-Cu alloy, the environment resistance was further improved.

In light of the above-described experiment results, in the present invention, a Ag-Bi-Cu alloy, preferably a Ag-Bi-Cu-rare earth element alloy as a reflective film for a read-only optical information recording medium being extremely superior in durability was specified.

Next, each element constituting a Ag-base alloy used in the present invention will be described in detail below.
In addition, in the following description, "%" showing the composition ratio of each element means "at%".

Bi: 0.01 to 1.0% Bi is an element contributing to aggregation inhibition (maintenance of crystalline texture stability and surface smoothness) or the like when being kept in a high-temperature, high humidity environment, and an accelerated environment resistance characteristic or light resistance is improved by the addition of Bi. To effectively exert the above-described effect, the lower limit of the amount of Bi is fixed at 0.01%. In the case where the amount of Bi is less than 0.01%, surface roughness is increased, and a decline in reflectivity after an accelerated environmental test is increased. On the other hand, when the amount of Bi is larger than 1.0%, a decline in reflectivity after a light resistance test is increased, so the upper limit of the amount of Bi is fixed at 1.0%. The amount of Bi is preferably within a range from 0.05% to 0.8% both inclusive, and more preferably within a range from 0.1% to 0.6% both inclusive.

Cu: 0.1 to 13.0% Cu is an element contributing to an improvement in repeating reproduction durability. In the case where the amount of Cu is less than 0.1%, a desired repeating reproduction characteristic is not obtained, so the lower limit of the amount of Cu is fixed at 0.1%. The amount of Cu is preferably 0.2% or over, and more preferably 0.3% or over. On the other hand, when the amount of Cu exceeds 13.0%, initial reflectivity declines, and, for example, a necessary signal for reproduction of an optical disk using blue laser light is not obtained, so the upper limit of the amount of Cu is fixed at 13.0%. Moreover, in the case where the reflective film of the invention is applied specifically to a dual-layer optical disk, as will be described later, the upper limit of the amount of Cu is preferably 3.0%, and more preferably 2.0%.

Now, the reason why the upper limit of the amount of Cu is changed depending on the kind of an optical disk to be applied will be described below. For example, in a reflective film of the above-described Patent Document 4 by the same applicants as the present applicants, the upper limit of the amount of Cu is 3% which is much lower than the upper limit (13%) of the amount of Cu in the invention, and the reason is that in the above-described patent document, a decline in reflectivity and a decline in thermal conductivity were attempted under the assumption that the reflective film was mainly applied to a DVD which was a mainstream at the time of the application (2002). At first, with regard to reflectivity, in a standard for DVD, it is specified that in the case of an optical disk, reflectivity of 45% to 65% in a single-layer optical disk and 18% to 30% in a dual-layer optical disk with respect to laser light with a wavelength of 650 nm are secured, and in particular, in the case where the reflective film is used in the dual-layer optical disk, a layer on a far side from the laser light incident side is read out, so high reflectivity is desired. In Patent Document 4, to satisfy the above-described standard, an experiment sample of a Ag alloy thin film single layer achieving reflectivity of 88% or over is considered as an acceptance criterion, thereby the upper limit of the additive amount of Cu is set to 3%.

However, in a Blu-ray Disc (BD), an HD DVD or the like which has developed after the application of Patent Document 4, blue laser light with a wavelength 405 nm is used, and the reflectivity specified by the standard is approximately 40% in a single-layer optical disk and approximately 15% in a dual-layer optical disk. In other words, a reflectivity characteristic desired for a reflective film of an optical disk using blue laser light is very low (in particular, in a single-layer disk), compared to the DVD. On the other hand, with regard to thermal conductivity, the situation at the time of the application of Patent Document 4 was that a standard for thermal conductivity was not established and to obtain a good recording signal through the use of an organic recording film, high thermal conductivity was demanded of the reflective film. However, the situation at present is that the recording layer is replaced with an inorganic recording film, and an optical disk using the inorganic recording film does not necessarily have high thermal conductivity, and high thermal conductivity is not demanded as strictly as at the time of the application of Patent Document 4. Under such a change in circumstances, when BDs including reflective films of Ag-Bi-Cu alloys including different amount of Cu were actually formed, and the reflectivity of each of the BDs was measured, it turned out that as shown by the undermentioned example, even if Cu was added up to an amount of 13.0%, a standard for reflectivity necessary for the BD (approximately 40% in a single-layer optical disk) could be sufficiently secured. Therefore, in the present invention which is expected to be applied specifically to a BD, the upper limit of the amount of Cu is set to 13.0%.

In addition, preferably, the upper limit of the amount of Cu is appropriately changed depending on the number of recording layers in an optical disk in the strict sense. For example, in the case where a Ag-base alloy is used as the material of a reflective film for an optical disk including two or more recording layers, when the reflectivity of a first recording surface attributable to light absorption by a second reflective film on a side closer to a laser incident side is considered, the reflectivity of the reflective film is desired to be higher than that in the case of a single layer. Therefore, the upper limit of the amount of Cu is preferably 3%.

Thus, the upper limit of the amount of Cu is 13.0% (3% in the case of an optical disk including two or more layers), which is larger than the upper limit of the content of the above-described Bi or a rare earth element as an undermentioned selection element. Typically, when an additive element is added to Ag, the initial reflectivity tends to decline, but Cu has a low effect of reducing initial reflectivity by the addition of Cu, compared to Bi or the rare earth element, so the additive amount can be increased.

The Ag-base alloy of the invention basically includes Bi and Cu within the above-described ranges, and Ag and an unavoidable impurity constitute the rest part of the Ag-based alloy.

However, to aim at a further improvement in characteristics, the rare earth element may be added within a range from 0.05% to 1.0% both inclusive, thereby as in the case of Bi, the environment resistance is improved.

The rare earth element used in the present invention means an element group including the lanthanoid elements (total 15 elements including atomic number 57, La through atomic number 71, Lu in the periodic table) plus Sc (scandium) and Y (yttrium). Only one kind or a combination of two or more kinds selected from them may be used. Among them, Nd, Sm (samarium), Tb (terbium), Y and Gd (gadolinium) are preferable, and Nd is the most preferable.

The content of the rare earth element is preferably within a range from 0.05% to 1.0% both inclusive. In the case where the content of the rare earth element is less than 0.05%, aggregation is not inhibited, the crystalline texture stability is not sufficiently maintained, the surface roughness is increased, and a decline in reflectivity after an accelerated environmental test is increased. On the other hand, when the content of the rare earth element exceeds 1.0%, a decline in reflectivity after an accelerated light irradiation test occurs, so the upper limit is preferably 1.0%. The lower limit of the content of the rare earth element is more preferably 0.1%, and the upper limit of the content of the rare earth element is more preferably 0.8%, and still more preferably 0.6%.

Mainly in light of reflectivity, the upper limit of the total amount of elements (Bi and Cu, preferably the rare earth element) added to Ag is preferably 20% in the case where the elements are used for the reflective film of a single-layer disk, and 5% in the case where they are used for a dual-layer optical disk. As described above, typically, when an element is added to Ag to alloy them, the initial reflectivity tends to decline, but the total amount of the additive elements is determined so as to satisfy the specified value of reflectivity in a BD-ROM disk (approximately 40% in a single-layer optical disk and approximately 15% in a dual-layer optical disk).

The Ag-base alloy used in the invention is useful as the material of the reflective film for an optical disk, and is applicable to an optical disk including one or more recording layers. The thickness of the reflective film is preferably 5 to 50 nm in light of practical use. In the case where the thickness of the reflective film is less than 5 nm, sufficient reflectivity cannot be secured, and it is difficult to read out a signal. On the other hand, it is known that when the thickness of the reflective film exceeds 50 nm, the clarity of a reproduction signal is lost (a jitter value increases); therefore, the upper limit is preferably 50 nm. More specifically, a preferable thickness of the reflective film depends on the recording layer of an optical disk, and, for example, in the case where the reflective film is used for a single-layer optical disk, the thickness is preferably within a range from approximately 20 to 50 nm. On the other hand, the thickness of a second reflective film on the laser incident side of a dual-layer optical disk is preferably within a range of approximately 5 to 30 nm. When the thickness of the second reflective film exceeds 30 nm, sufficient light for reproduction on the recording surface of a first light transmissive layer cannot pass through the second reflective film. On the other hand, in the case where the thickness of the second reflective film is less than 5 nm, sufficient reflected light for reproduction on the recording surface of a second light transmissive layer is not obtained. The thickness of the first reflective film is preferably 20 to 50 nm.

Up to this point, the Ag-base alloy used in the invention is described.

The read-only optical information recording medium of the invention is characterized by using the above-described Ag-base alloy as the material of the reflective film, and the configuration or type (kinds of the light transmissive layer, the substrate and the like) of an optical disk to which the Ag-base alloy is applied is not specifically limited, and any typically used optical disk can be used.

Moreover, the kind of the substrate is not specifically limited, and resins widely used for substrates for optical disks, for example, a polycarbonate resin, an acrylic resin and the like can be used. In consideration of price or mechanical characteristics, polycarbonate is preferably used.

The thickness of the substrate is preferably within a range of 0.4 to 1.2 mm. Moreover, the depth of a pit formed on the substrate is preferably within a range of 50 to 100 nm.

Moreover, the kind of the light transmissive layer is not limited, and, for example, an ultraviolet curable resin, a polycarbonate resin or the like can be used. The thickness of the light transmissive layer is preferably approximately 100 µm in a single-layer optical disk, and in a dual-layer optical disk, the thickness of the first light transmissive layer is preferably approximately 25 µm, and the thickness of the second light transmissive layer is preferably approximately 75 µm.

The Ag-base alloy thin film used in the invention can be formed by, for example, a sputtering method, a vapor deposition method or the like, but the sputtering method is preferable. It is because by the sputtering method, the above-described alloy element is uniformly dispersed into a Ag matrix, so a homogeneous film is obtained, and stable optical characteristics or durability can be obtained.

A sputtering target used in the sputtering method can be manufactured by any of a melting/casting method, a powder sintering method, a spray forming method and the like, and in particular, the sputtering target is preferably manufactured by a vacuum melting/casting method. A Ag-base alloy sputtering target manufactured by a vacuum melting/casting method includes a smaller content of an impurity component such as nitrogen or oxygen than a sputtering target manufactured by any other method, and when the sputtering target is used, the sputtering rate is stabilized, and the first reflective film or the second reflective film formed through the use of this sputtering target is extremely superior in characteristics such as stability of the reflective film composition, and an optical disk with high performance and high reliability can be provided.

### Examples

Hereinafter, the present invention will be described more concretely referring to examples. However, the present invention is not limited by undermentioned examples, but the invention can be embodied by appropriately modifying them within the range conforming to the aforementioned and undermentioned purport of the invention, and all modifications are included in the technical scope of the invention.

### Example 1

In the present example, single-layer BD-ROMs were formed by the following steps.

At first, a substrate with a thickness of 1.1 mm was obtained by injection-molding polycarbonate through the use of a Ni (nickel) stamper having lands and pits. On the other hand, by a vacuum melting/casting method, Ag-base alloy sputtering targets including various components shown in Table 1 were formed.

Through the use of each of the Ag-base alloy sputtering targets obtained in such a manner, a reflective film with a thickness of 35 nm was formed on the above-described substrate by DC magnetron sputtering. Sputtering conditions included an Ar gas flow rate of 20 sccm, an Ar gas pressure of 2 mTorr (0.266 Pa), film formation power of DC400 W, and ultimate vacuum of 2.0×10⁻⁶ Torr (266×10⁻⁶ Pa) or less. Next, an ultraviolet curable resin was applied by a spin coat method so as to have a thickness of 100 µm, and the resin was cured by ultraviolet irradiation to form a light transmissive layer, thereby single-layer BD-ROMs were obtained.

The following characteristics of the single-layer BD-ROMs obtained in such a manner were evaluated.

### (Measurement of reflectivity)

In BDs, reflectivity is defined as the maximum value (R8H) of reflectivity of a 8T signal in a 17PP modulation signal. In the example, an information signal was reproduced from a light transmissive layer side by a laser pickup having a laser wavelength of 405 nm and an objective lens numerical aperture (NA) of 0.85, and the reproduced signal was converted through the use of a signal of a disk of which the reflectivity was previously known to determine the reflectivity (the initial reflectivity before performing the following test) of the single-layer BD-ROM by calculation. A single-layer BD-ROM having reflectivity of 35% or over is considered as an acceptable one.

### (Environment resistance)

A high-temperature high-humidity test in which the BDs were stored for 240 hours in an air atmosphere at a temperature of 80°C and a relative humidity of approximately 85% was performed to measure the change amount of reflectivity before and after the test. In the example, a single-layer BD-ROM having a change amount of reflectivity before and after an accelerated environmental test of within ±3% is considered as an acceptable one.

### (Light resistance)

An accelerated light irradiation test for evaluating light resistance was performed by applying light with an intensity 20 times higher than that of an ultraviolet ray with a wavelength of 300 to 400 nm applied by an indoor illuminating lamp for 240 hours to evaluate light resistance on the basis of the change amount of reflectivity before and after the test. More specifically, an experiment was performed by using a lamp FHF32EX of Toshiba Lighting & Technology Corporation and placing the light transmissive layer of each of the BD-ROMs obtained in the above-described manner in a position 30 cm away from the lamp so as to face the lamp to measure the change amount of reflectivity. In the example, a BD-ROM having a change amount of reflectivity before and after the accelerated light irradiation test of within ±3% is considered as an acceptable one.

(Repeating reproduction durability) After the reproduction of a single data unit was performed 12 millions times with reproduction laser power of 0.35 mW at a linear velocity of 9.8 m/s, a symbol error rate (SER) as an indicator of read signal error was measured. A BD-ROM having an SER of 10×10⁻⁴ or less is considered as an acceptable one. In addition, it was confirmed that in any BD-ROM, the initial SER was 1×10⁻⁵ or less.

All of the results of the initial reflectivity, the environment resistance, the light resistance and the repeating reproduction durability obtained in the above-described matter are shown in Table 1. Table 1 has a column showing overall rating, and a BD-ROM in which all of the characteristics were acceptable is indicated by °, and a BD-ROM in which some of the characteristics was not acceptable is indicated by ×.

**[Table 1]**

| No. | REFLECTIVE FILM COMPOSITION | REFLECTIVITY | ENVIRONMENTAL RESISTANCE | | LIGHT RESISTANCE | | REPEATING REPRODUCTION DURABILITY | | OVERALL RATING |
|---|---|---|---|---|---|---|---|---|---|
| | | RATING | REFLECTIVITY CHANGE AMOUNT (%) | RATING | REFLECTIVITY CHANGE AMOUNT (%) | RATING | SER (×10⁻⁴) | RATING | |
| 1 | Ag-1.0at%Pd-1.7at%Cu | ○ | -0.8 | ○ | -4.6 | × | 0.6 | ○ | × |
| 2 | Ag-0.4at%Nd-0.6at%Cu | ○ | -1.9 | ○ | -3.9 | × | 3 | ○ | × |
| 3 | Ag-0.35at%Bi-0.2at%Nd | ○ | -0.9 | ○ | -2.0 | ○ | >300 | × | × |
| 4 | Ag-1.0at%Bi-1.1at%Nd | ○ | -2.5 | ○ | -3.7 | × | >300 | × | × |
| 5 | Ag-0.35at%Bi-0.6at%Cu | ○ | -1.1 | ○ | -2.7 | ○ | 0.4 | ○ | ○ |
| 6 | Ag-1.0at%Bi-2.0at%Cu-0.1at%Nd | ○ | 0.7 | ○ | -1.1 | ○ | 0.7 | ○ | ○ |
| 7 | Ag-0.35at%Bi-0.6at%Cu-0.2at%Nd | ○ | -0.4 | ○ | -2.4 | ○ | 0.5 | ○ | ○ |
| 8 | Ag-0.35at%Bi-2.0at%Cu-0.1at%Nd | ○ | 0.7 | ○ | -1.1 | ○ | 0.1 | ○ | ○ |
| 9 | Ag-0.35at%Bi-7.0at%Cu-0.1at%Nd | ○ | -2.1 | ○ | -1.4 | ○ | 0.3 | ○ | ○ |
| 10 | Ag-0.35at%Bi-13.0at%Cu-0.1at%Nd | ○ | -2.6 | ○ | -1.0 | ○ | 0.8 | ○ | ○ |
| 11 | Ag-0.35at%Bi-20.0at%Cu-0.1at%Nd | × | -3.1 | ○ | -2.5 | ○ | 0.4 | ○ | × |
| 12 | Ag-0.35at%Bi-2.0at%Cu-0.2at%Sm | ○ | -1.1 | ○ | -2.1 | ○ | 0.3 | ○ | ○ |
| 13 | Ag-0.35at%Bi-2.0at%Cu-0.2at%Tb | ○ | -1.2 | ○ | -3.1 | ○ | 0.6 | ○ | ○ |
| 14 | Ag-0.35at%Bi-2.0at%Zn-0.1at%Nd | ○ | - | - | - | - | >300 | × | × |
| 15 | Ag-0.35at%Bi-1.0at%Pd-0.1at%Nd | ○ | - | - | - | - | 80 | × | × |
| 16 | Ag-0.35at%Bi-1.0at%Au-0.1at%Nd | ○ | - | - | - | - | 300 | × | × |
| 17 | Ag-0.35at%Bi-0.1at%Nd-1.0at%Pt | ○ | - | - | - | - | 180 | × | × |

The following can be considered from Table 1.

No.5 was a Ag-Bi-Cu alloy satisfying requirements of the invention, and Nos.6 to 10 and 12 and 13 were Ag-Bi-Cu-rare earth element alloys satisfying preferable requirements of the invention, and all of them had high reflectivity, and were superior in all kinds of durability.

On the other hand, the following examples not satisfying some of requirements of the invention had the following failures.

### (Nos.1 and 2)

No. 1 and No. 2 were examples in which Bi was not added. In the examples, No. 1 was an example in which Pd was added as a Z-group element, but No. 1 was inferior in light resistance. No. 2 was an example in which instead of a Z-group element, Nd was added. The environment resistance was improved by adding Nd instead of Bi, but No. 2 was inferior in light resistance.

It was found out from these results that to improve light resistance, the addition of Bi was absolutely necessary.

### (Nos. 3, 4, 11 and 14 to 17)

Nos. 3, 4, 11 and 14 to 17 were examples in which Cu was not added (Nos. 3, 4 and 14 to 17), or the additive amount of Cu was large (No. 11).

As shown in Table 1, the above-described examples in which Cu was not added were inferior in the repeating reproduction durability. Moreover, in No. 4, the additive amount of Nd as a rare earth element was large, so the light resistance also declined. Further, when the additive amount of Cu was large as in the case of No. 11, the total amount of alloy elements was increased, thereby the reflectivity declined.

Nos. 15 to 17 were examples in which an element except for Cu was used as a Z-group element, and in all of the examples, an improvement in repeating reproduction durability was not observed. Moreover, No. 14 was an example in which Zn was used instead of a Z-group element, and an improvement in repeating reproduction durability was not observed. In addition, in Nos. 14 to 17, only repeating reproduction durability was assessed, and experiments on environment resistance and light resistance were not performed.

It was found out from the above-described experiment results that to improve the repeating reproduction durability, the addition of Cu was absolutely necessary, and when Cu was added within a range specified by the invention, high reflectivity and superior durability were obtained.
Moreover, it was confirmed that an optical information recording medium including a reflective film of a Ag-Bi-Cu alloy and a Ag-Bi-Cu-rare earth element alloy had high reflectivity, and was superior in all of the environment resistance, the light resistance and the repeating reproduction durability.

### Example 2

In the example, dual-layer BD-ROMs were formed by the following steps. In this case, Ag alloy films shown in Table 2 were used to form the first reflective film and the second reflective film.

At first, a substrate with a thickness of 1.1 mm was obtained by injection-molding polycarbonate through the use of a Ni stamper having lands and pits. On the other hand, by a vacuum melting/casting method, Ag-base alloy sputtering targets including components shown in Table 2 were formed.

Through the use of each of the Ag-base alloy sputtering targets obtained in such a manner, the first reflective film with a thickness of 40 nm was formed on the above-described substrate by DC magnetron sputtering. Sputtering conditions were the same as those in the above-described example 1. Next, an ultraviolet curable resin was applied by a spin coat method so as to have a thickness of 25 µm, and the resin was cured by ultraviolet irradiation to form the first light transmissive layer (with a thickness of 25 µm).

Moreover, the second reflective film with a thickness of 20 nm was formed by DC magnetron sputtering. Sputtering conditions were the same as those in the above-described example 1, except that the film formation power was changed to DC100 W. Next, an ultraviolet curable resin was applied by a spin coat method so as to have a thickness of 75 µm, and the resin was cured by ultraviolet irradiation to form the second light transmissive layer (with a thickness of 75 µm), thereby the dual-layer BD-ROMs were obtained.

The SER of each of the dual-layer BD-ROMs obtained in such a manner was measured as in the case of the above-described example 1. In the example, a dual-layer BD-ROM having an SER 10x10⁻⁴ or less on both of the first information recording surface and the second information recording surface is considered as an acceptable one.

These results are shown in Table 2.

**[Table 2]**

| No. | REFLECTIVE FILM COMPOSITION | REPEATING REPRODUCTION DURABILITY | | | |
|---|---|---|---|---|---|
| | | FIRST INFORMATION RECORDING SURFACE | | SECOND INFORMATION RECORDING SURFACE | |
| | | SER (×10⁻⁴) | RATING | SER (×10⁻⁴) | RATING |
| 1 | Ag-0.35at%Bi-0,6at%Cu-0.2at%Nd | 0.6 | ○ | 0.5 | ○ |
| 2 | Ag-0.35at%Bi-0.2at%Nd | >300 | × | >300 | ○ |

In Table 2, while No. 2 not including Cu of Table 2 was inferior in the repeating reproduction durability of the first information recording surface, No. 1 including Cu within the range of the invention of Table 2 was superior in the repeating reproduction durability. From the experiment results, as in the case of the single-layer BD-ROM, an effect of improving the repeating reproduction durability by the addition of Cu was confirmed also in the dual-layer BD-ROM. In addition, although it is not shown in Table 2, it was confirmed that No. 1 of Table 2 had high reflectivity, and was superior in both of the environment resistance and the light resistance.

## Claims

1. An optical information recording medium being a read-only optical information recording medium in which at least one reflective film and at least one light transmissive layer are laminated in order on a substrate,
wherein the reflective film is made of a Ag-base alloy including 0.01 to 1.0 at% of Bi and 0.1 to 13.0 at% of Cu.

2. An optical information recording medium being a read-only optical information recording medium in which a first reflective film, a first light transmissive layer, a second reflective film and a second light transmissive layer are laminated in order on a substrate,
wherein the first reflective film and the second reflective film are the same as or different from each other, and are made of a Ag-base alloy including 0.01 to 1.0 at% of Bi and 0.1 to 3.0 at% of Cu.

3. The optical information recording medium according to claim 1 or 2, wherein the Ag-base alloy includes 0.05 to 1.0 at% of a rare earth element.

4. The optical information recording medium according to claim 3,
wherein the Ag-base alloy includes Nd as the rare earth element.

5. The optical information recording medium according to claim 1,
wherein the reproduction of information is performed by a blue laser.
